# EUROPÄISCHE PATENTSCHRIFT

(11) **EP 0 613 338 B1**
(45) Veröffentlichungstag und Bekanntmachung des Hinweises auf die Patenterteilung: **13.11.1996**
(21) Anmeldenummer: 94101860.8
(22) Anmeldetag: 08.02.1994
(51) Int. Cl.: H05K 13/00, C09J 7/02

(54) **Selbstklebender Verdecklungsfilm für die Verpackung elektronischer Bauelemente**
Selfadhesive covertape for electronic components storage
Film autocollant de fermeture pour emballage de composants électroniques

(30) Priorität: 26.02.1993 DE 4305910
(43) Veröffentlichungstag der Anmeldung: 31.08.1994
(73) Patentinhaber: Beiersdorf Aktiengesellschaft, D-20245 Hamburg (DE)
(72) Erfinder: Harder, Christian, Dr., D-22589 Hamburg (DE); Höwe, Bernd, D-22869 Schenefeld (DE); Kuhlmann, Karl, D-22453 Hamburg (DE)

(56) Entgegenhaltungen:
- EP-A- 0 051 168
- EP-A- 0 300 838
- DE-A- 3 928 712
- DE-A- 3 928 713
- US-A- 3 725 115
- DATABASE WPI Week 8133, Derwent Publications Ltd., London, GB; AN 81-59576D & JP-A-56 079 112 (RICOH) 29. Juni 1981

## Beschreibung

Die Erfindung betrifft einen selbstklebenden Verdeckelungsfilm für die Verpakkung elektronischer Bauelemente (Gurte), die für den Einsatz in schnell laufenden Automaten vorgesehen sind.

Elektronische Bauelemente, insbesondere mikroelektronische Bauteile, werden in tiefezogenen Kavernen thermoplastischer Kunststoffbahnen verpackt, wie z.B. in Folienbahnen aus Polyvinylchlorid (PVC), Polystyrol (PS) oder Polycarbonat (PC), wobei diese Kunststoffe sowohl rein als auch mit Ruß gefüllt verarbeitet werden. Diese sogenannten Gurte werden seit vielen Jahren mit Verdeckelungsfilmen mittels hot-melt Klebern verschlossen und in Automaten verarbeitet, d.h. geöffnet und die in ihnen verpackten Bauelemente entnommen.

Es gibt aber auch bereits selbstklebende Verdeckelungsfilme für derartige Anwendungen, deren Klebeschicht mittig durch eine leitfähige bzw. nicht leitfähige Kunststoffolie inaktiviert wurde. Dieser inaktivierende Streifen deckt die Öffnungen des Trägergurtes ab, damit die Bauelemente nicht mit der Selbstklebeschicht in Berühung kommen. Die an den beiden Rändern der Verschlußbahn verbleibenden Kleberstreifen von 0,5-1,2 mm Breite verbinden dieselbe mit dem Trägergurt. Als ausreichende Haftkraft wird dabei eine Abzugskraft der Verschlußbahn von dem Trägergurt in dem Bereich von 20 - 100 cN angesehen.

Derartige Verdeckelungsfilme sind im Stand der Technik beschrieben und auch im Handel erhältlich, so als Produkt "cover tape YR 2666" der Firma 3M. Beschrieben werden derartige Produkte zudem im Siemens-Patent EP 51.168, ferner auch in der DE-OS 39 28 712, DE-OS 39 28 713 und der EP-OS 300 838.

Die Produkte des Standes der Technik haben jedoch Nachteile, die sich insbesondere in der Praxis bemerkbar machen. Denn derartige Verpackungen mit elektronischen Bauteilen werden in schnell-laufenden Automaten eingesetzt, in denen kleinste Störungen oder Ungleichmäßigkeiten Konsequenzen für einen Gesamtprozeß bewirken, in den der Einsatz einer so verdeckelten Verpackung integriert ist. So können etwa ungleichmäßig haftende Verdeckelungsfilme zu Problemen führen, als Folge von unterschiedlichen Polaritäten der eingesetzten unterschiedlichen Materialien, so daß also der Verdeckelungsfilm gleich und gleich gut auf unterschiedlichen Verpackungs-Gurten haften muß, und zwar sofort und auch ausreichend stark. Zudem darf es beim Abziehen des Verdeckelungsfilms in einem solchen schnell laufenden Automaten nicht etwa zu Kleber-Rückständen auf dem Verpackungs-Gurt kommen, denn solche Rückstände können sich, obwohl vielleicht nur in sehr geringer Menge an einzelnen Stellen, doch im Gesamt-Prozeß zu störenden Mengen an einzelnen Maschinenteilen aufbauen bzw. ansammeln und dann den Arbeitsablauf stören. Jeglicher Rückstand von Klebmassen ist also zu vermeiden, insbesondere auch nach Einwirkung von Feuchtigkeit und Wärme auf die verdeckelte Verpackung, wie sie von vielen Gurt-Verarbeitern etwa gemäß Tropentest nach IEC 68-2-3 gefordert wird.

Klebmassen, die als polares Monomer eine ungesättigte Carbonsäure und als weitere Monomerkomponente Stearylacrylat enthalten, sind aus JP-A-079 112 bekannt.

Aufgabe der Erfindung war es, hier Abhilfe zu schaffen und die Nachteile von Produkten des Standes der Technik zu vermeiden, zumindest aber für die Praxis vertretbar zu vermindern.

Die Erfindung betrifft demgemäß einen selbstklebenden Verdecklungsfilm mit den Merkmalen des Anspruchs 1 und dessen Verwendung gemäß Anspruch 11. Besondere Ausführungsformen sind in den abhängigen Patentansprüchen näher gekennzeichnet.

In an sich bekannter Weise werden dabei als Haftkleber Copolymerisate auf der Basis verschiedener Acrylatverbindungen eingesetzt, wie Acrylsäure, Butylacrylat, Methylhexylacrylat und Stearylacrylat, da diese Klebstoffgruppe im allgemeinen eine sehr gute Temperatur- und Alterungsbeständigkeit besitzt. Um den besonderen Anforderungen aufgrund der unterschiedlichen zu beklebenden Untergründe im vorliegenden Fall aber Rechnung zu tragen, wird erfindungsgemäß eine besondere Mischung von Acrylat-Klebmassen eingesetzt, nämlich zum einen eine stark polare Komponente und zum anderen eine eher unpolare Komponente. Dies führt zu einem problemlosen, schnellen und dauerhaften Verkleben auf den unterschiedlichsten Gurtungsbändern, wie sie in der Praxis eingesetzt werden. Zusammen mit dem verwendeten Haftvermittler (Primer) führt dies zu einer störungsfreien Anwendung der erfindungsgemäß verschlossenen Verpakkungen in schnell laufenden Automaten, ohne daß störende Rückstände von Klebmasse den Prozeß behindern und ohne daß störende Ungleichmäßigkeiten im Abzugsverhalten zu sich aufbauenden Schwingungen führen.

Als Haftvermittler (Primer) eignen sich insbesondere solche vom Typ eines reaktiven Acrylatcopolymeren mit einem Epoxidhärter.

Als Träger für den Verdeckelungsfilm eignet sich insbesondere eine Polyesterfolie, in Dicken von 0,015 bis 0,050 mm.

Im folgenden soll die Erfindung anhand von Beispielen erläutert werden, ohne diese damit aber unnötig beschränken zu wollen. % sind Gewichts-%, Teile sind Gewichts-Teile.

### Beispiel

Eine Polyesterfolie Typ Hostaphan RN der Firma Hoechst in 0,025 mm Dicke wird beschichtet mit einem Haftvermittler auf Basis eines Acrylatcopolymeren. Als Acrylatcopolymer wurde eine 46%ige Dispersion der Firma ICI eingesetzt, das NeoTac A-570, und als Härter das wasserdispergierbare Epoxidharz Epi-Rez WD-510 der Interez Inc. Beide Substanzen reagieren bei Raumtemperatur zu einem Film, der in MEK, Aceton und Isopropanol unlöslich ist und einen Erweichungspunkt größer als 190°C besitzt. Das Mischungsverhältnis NeoTac A-570: Epi-Rez WD-510 betrug 88,5 : 11,5.

Der Auftrag erfolgt mittels eines Drahtrakels aus einer 10%igen Dispersion, Auftragsgewicht 0,3 g/m².

Der Aufstrich der Selbstklebemasse erfolgte aus einer 40%igen Lösung heraus und betrug 42 g/m². Aufgetragen wurde eine Selbstklebemasse bestehend aus 80 Teilen eines Acrylatcopolymerisats mit 9% Acrylsäure und 20 Teilen eines Acrylatcopolymerisats mit 20% Stearylacrylat.

Das fertige Klebeband wurde masseseitig einer ES-Bestrahlung unterzogen (210 KV Strahlspannung und einer Dosis von 40 KGy), um das gewünschte Eigenschaftsprofil der Klebmasse zu erreichen.

## Patentansprüche

1. Selbstklebender, einen Folienträger und eine mittig nicht-klebend abgedeckte Klebeschicht aufweisender Verdeckelungsfilm für die Verpackung elektronischer Bauelemente in tiefgezogenen Kavernen von Folienbahnen dadurch gekennzeichgt, daß die Klebeschicht aus einer Mischung zweier Acrylat-KIebmassenkomponenten von unterschiedlicher Polarität besteht, wobei die eine, stark polare Komponente einen Anteil von 1 % bis 20 % Acrylsäure in der Monomer-Zusammensetzung enthält, und die andere, eher unpolare Komponente einen Anteil von 5 % bis 50 % Stearylacrylat in der Monomer-Zusammensetzung enthält, und wobei sich zwischen der Klebeschicht und dem Folienträger des Verdeckelungsfilms ein Haftvermittler befindet.

2. Verdeckelungsfilm nach Anspruch 1, dadurch gekennzeichnet, daß die polare Komponente 6 - 10 % Acrylsäure enthält.

3. Verdeckelungsfilm nach Anspruch 1, dadurch gekennzeichnet, daß die polare Komponente 8 % Acrylsäure enthält.

4. Verdeckelungsfilm nach Anspruch , dadurch gekennzeichnet, daß die unpolare Komponente 10 - 30 % Stearylacrylat enthält.

5. Verdeckelungsfilm nach Anspruch 1, dadurch gekennzeichnet, daß die unpolare Komponente 20 % Stearylacrylat enthält.

6. Verdeckelungsfilm nach Anspruch 1, dadurch gekennzeichnet, daß die Klebeschicht mittig durch eine ggf. leiffähige Kunststoffolie abgedeckt ist.

7. Verdeckelungsfilm nach Anspruch 1, dadurch gekennzeichnet, daß der Folienträger des Verdeckelungsfilms aus Polyester besteht.

8. Verdeckelungsfilm nach Anspruch 1, dadurch gekennzeichnet, daß der Haftvermittler aus einem reaktiven Acrylcopolymeren mit einem Epoxidhärter besteht, insbesondere einem solchen auf Basis Bisphenol A.

9. Verdeckelungsfilm nach Anspruch 8, dadurch gekennzeichnet, daß im Haftvermittler das Gewichts-Verhältnis von reaktivem Acrylcopolymer zu Epoxidhärter 95 : 5 bis 80 : 20, insbesondere 88,5 : 11,5 ist.

10. Verdeckelungsfilm nach Anspruch 1, dadurch gekennzeichnet, daß die Klebeschicht einer Elektronen-Bestrahlung unterzogen ist.

11. Verwendung eines selbstklebenden Verdeckelungsfilms nach einem der Ansprüche 1 - 10 zum Verschließen von Verpackungen für elektronische Bauelemente, die für den Einsatz in schnellaufenden Automaten vorgesehen sind.

## Claims

1. Self-adhesive lidding film having a film support and an adhesive layer covered in a non-adhesive manner in the centre, for packaging electronic components in thermoformed caverns of film sheeting, characterized in that the adhesive layer comprises a mixture of two acrylate adhesive composition components of different polarity, the first, highly polar component containing from 1% to 20% of acrylic acid in the monomer composition, and the other, rather nonpolar component containing from 5% to 50% of stearyl acrylate in the monomer composition, and where an adhesion promoter is present between the adhesive layer and the film support of the lidding film.

2. Lidding film according to Claim 1, characterized in that the polar component contains 6-10% of acrylic acid.

3. Lidding film according to Claim 1, characterized in that the polar component contains 8% of acrylic acid.

4. Lidding film according to Claim [lacuna] , characterized in that the nonpolar component contains 10-30% of stearyl acrylate.

5. Lidding film according to Claim 1, characterized in that the nonpolar component contains 20% of stearyl acrylate.

6. Lidding film according to Claim 1, characterized in that the adhesive layer is covered in the centre by an optionally conductive plastic film.

7. Lidding film according to Claim 1, characterized in that the film support of the lidding film comprises polyester.

8. Lidding film according to Claim 1, characterized in that the adhesion promoter comprises a reactive acrylic copolymer with an epoxy curing agent, in particular based on bisphenol A.

9. Lidding film according to Claim 8, characterized in that the weight ratio between the reactive acrylic copolymer and the epoxy curing agent in the adhesion promoter is from 95 : 5 to 80 : 20, in particular 88.5 : 11.5.

10. Lidding film according to Claim 1, characterized in that the adhesive layer has been exposed to electron irradiation.

11. Use of a self-adhesive lidding film according to one of Claims 1 - 10 for sealing packaging for electronic components which are intended for use in high-speed automatic machines.

## Revendications

1. Film autocollant de fermeture, présentant un support en feuille et une couche adhésive, recouverte au centre de manière non collante, pour l'emballage de composants électroniques dans des cavités embouties de bandes de feuilles, caractérisé en ce que la couche adhésive se compose d'un mélange de deux constituants de masses adhésives d'acrylate de polarité différente, l'un des constituants, fortement polaire, contenant une proportion de 1 à 20 % d'acide acrylique dans la composition de monomères et l'autre constituant, plutôt non polaire, contenant une proportion de 5 à 50 % d'acrylate de stéaryle dans la composition de monomères, et un promoteur d'adhésion se trouvant entre la couche adhésive et le support en feuille du film de fermeture.

2. Film de fermeture selon la revendication 1, caractérisé en ce que le constituant polaire contient 6 - 10 % d'acide acrylique.

3. Film de fermeture selon la revendication 1, caractérisé en ce que le constituant polaire contient 8 % d'acide acrylique.

4. Film de fermeture selon la revendication 1, caractérisé en ce que le constituant non polaire contient 10 - 30 % d'acrylate de stéaryle.

5. Film de fermeture selon la revendication 1, caractérisé en ce que le constituant non polaire contient 20 % d'acrylate de stéaryle.

6. Film de fermeture selon la revendication 1, caractérisé en ce que la couche adhésive est recouverte au centre par une feuille de matière synthétique, le cas échéant, conductrice.

7. Film de fermeture selon la revendication 1, caractérisé en ce que le support en feuille du film de fermeture se compose de polyester.

8. Film de fermeture selon la revendication 1, caractérisé en ce que le promoteur d'adhésion se compose d'un copolymère acrylique réactif à agent de durcissement époxyde, en particulier avec un agent de ce genre à base de bisphénol A.

9. Film de fermeture selon la revendication 8, caractérisé en ce que, dans le promoteur d'adhésion, le rapport pondéral du copolymère acrylique réactif à l'agent de durcissement époxyde est de 95:5 à 80:20, en particulier de 88,5:11,5.

10. Film de fermeture selon la revendication 1, caractérisé en ce que la couche adhésive est soumise à un bombardement d'électrons.

11. Utilisation d'un film autocollant de fermeture selon l'un quelconque des revendications 1 - 10, pour le scellement d'emballages pour composants électroniques, qui sont prévus pour l'utilisation dans des automates fonctionnant à haute vitesse.
